# EUROPEAN PATENT APPLICATION

(11) **EP 4 152 416 A1**
(43) Date of publication of application: **22.03.2023**
(21) Application number: 20935195.6
(22) Date of filing: 19.10.2020
(51) Int. Cl.: H01L 31/032

(54) **PRECURSOR SOLUTION OF COPPER-ZINC-TIN-SULFUR THIN FILM SOLAR CELL, PREPARATION METHOD THEREFOR, AND USE THEREOF**

(30) Priority: 15.05.2020 CN 202010410931
(71) Applicant: Nanjing University Of Posts And Telecommunications, JIANGSU 210003 (CN)
(72) Inventor: XIN, Hao, Nanjing, Jiangsu 210003 (CN); ZHANG, Yifan, Nanjing, Jiangsu 210003 (CN); GONG, Yuancai, Nanjing, Jiangsu 210003 (CN); NIU, Chuanyou, Nanjing, Jiangsu 210003 (CN); QIU, Ruichan, Nanjing, Jiangsu 210003 (CN)
(74) Representative: Frick, Robert
(86) International application number: PCT/CN2020/121966
(87) International publication number: WO 2021/227362

(57) **Abstract**

Disclosed are a precursor solution for a copper-zinc-tin-sulfurthin film solar cell, a preparation method therefor, and the use thereof. The present invention discloses two types of simple metal complexes which are capable of formulating a high-quality precursor solution. A precursor solution, which is formulated by using the metal complexes as precursor compounds, has a good stability, and can be used to prepare an impurity phase-free copper-zinc-tin-sulfur thin film light absorption material having a high crystallization quality and a good thin film morphology; and the copper-zinc-tin-sulfur thin film solar cell prepared therefrom has a high photoelectric conversion efficiency. The use of the metal complex simplifies the formulation procedure of the precursor solution, improves the quality of the precursor solution, improves the energy conversion efficiency of a photovoltaic device, and has a great industrial application potential.

## Description

### TECHNICAL FIELD

The present invention relates to the technical field of new energy photovoltaic power generation, in particular to a precursor solution of a copper-zinc-tin-sulfur thin film solar cell, a preparation method therefor, and a use thereof, in particular for the preparation and application of photovoltaic devices.

### BACKGROUND

The problem of energy shortage is a key problem that restricts the future development of human beings. The development and utilization of renewable energy is a high-quality solution to resolve this problem. Photovoltaic power generation technology is the most promising development direction of the renewable energy. In the past few decades, silicon-based solar cells represented by monocrystalline silicon and polycrystalline silicon as well as multi-component compound semiconductor thin film solar cells represented by cadmium telluride (CdTe) and copper indium gallium selenide (CIGS) have made great progress in energy efficiency and have been successfully commercialized. At present, the highest photoelectric conversion efficiency obtained by the single crystal silicon cell in the laboratory is 26.7%, and the highest photoelectric conversion efficiencies obtained by the CIGS and CdTe thin film solar cells in the laboratory are also 23.35% and 22.1%, respectively. However, due to the low absorption coefficient of silicon semiconductor, poor defect tolerance, potential environmental toxicity of Cd element, scarcity of crustal resources of In, Ga, Te elements and other factors, the production cost of these photovoltaic devices remains high, and it is difficult to compare with the traditional energy competes in the market. CZTS materials have similar crystal structures and optical band gaps to copper indium gallium selenide (CIGS) materials, the absorption coefficient in the visible light range is greater than 10⁴/cm, and the band gap is adjustable in the range of 1.0 eV to 1.5 eV, which match the optimal optical bandgap interval with solar cell materials. The CIGS materials have a higher theoretical conversion efficiency (32.3%). At the same time, the constituent elements of the CZTS materials are extremely abundant in the earth, low in price, safe and non-toxic, and therefore, it is a new low-cost photovoltaic material that is expected to replace copper indium gallium selenide. The preparation methods of CZTS film materials are mainly divided into two categories: a vacuum method and a solution method. The traditional vacuum preparation method is based on a high vacuum environment, and the material preparation process has a higher energy consumption and a lower material utilization rate. The solution method is based on a chemical solution, which does not require a vacuum environment, has a lower energy consumption, can be used for a large-area film formation, and has the advantages of improving the material utilization and the low-temperature processing, and the like.

The molecular precursor solution method has attracted the attention of researchers in recent years due to its simple process and a high conversion efficiency of the prepared cells. Although IBM reported in 2013 that a CZTSSe solar cell with an energy conversion efficiency of 12.6% was prepared by a precursor solution method based on a hydrazine solvent, the application of this method is limited due to the explosiveness and high toxicity of hydrazine. The Hillhouse research group at the University of Washington proposed a solution of a low-hazard dimethyl sulfoxide-based precursor solution, however, the improvement on the efficiency of the prepared solar cells is limited due to the existence of cationic redox reactions in the solution. In view of this, through the researches on the solution chemistry, the present invention discloses a simple, novel, stable, green and environment-friendly solution for preparing a precursor solution, which has been successfully applied to the preparations of CZTSSe film materials and CZTSSe solar cells, the prepared CZTSSe materials have a high crystal quality, a good morphology, no impurity phase, and its energy conversion efficiency of a photovoltaic device exceeds 10%, indicating a remarkable advancement of the present invention.

### SUMMARY

The objectives of the present invention lie in the following. In order to eliminate the deficiencies in the prior art, the present invention provides a precursor solution for a CZTS thin film solar cell, a cell preparation method therefor and an application thereof. For the objective of preparing a high-efficiency CZTS cell, a copper complex formed by a copper salt and a thiourea is taken as a copper precursor, and a tin complex formed by a tin salt with dimethyl sulfoxide or N, N-dimethylformamide is taken as a tin precursor, and a simple zinc salt is taken as a zinc precursor to prepare a stable precursor solution, to prepare an impurity phase-free CZTS light-absorbing material having a high-quality, and to prepare CZTS thin film solar cells with a high photoelectric conversion efficiency.

Technical solutions: in order to achieve the above-mentioned objectives, the technical solutions adopted in the present invention are as follows.

A precursor solution for CZTS solar cells is prepared by using a dimethyl sulfoxide (DMSO) or a N,N-dimethylformamide (DMF) as a solvent, and precursor compounds as solutes. The precursor compounds are metal complexes, a metal compound and a thiourea, wherein the metal complexes are a copper complex formed by a copper salt with a thiourea or thiourea derivative, and a tin complex formed by a tin salt and DMF or DMSO, and the metal compound is a divalent zinc salt. The above precursor compound is dissolved in the solvent of DMSO or DMF to obtain a stable, clear and transparent precursor solution.

Further, the copper complex is a complex formed by a copper salt with thiourea or its derivatives, including a complex of Cu(Tu)₃X formed by copper halide and thiourea, wherein X is a halogen element including F, Cl, Br, or I. The formed copper complex includes Cu(Tu)₃C1, [Cu₂(Tu)₆]C1₂•2H₂O, or Cu(Tu)₃Br, and the formed copper complex further includes a complex of Cu(DMTu)₃Br, Cu(TMTu)₃C1, or [Cu(ETu)₂Br]₂ formed by copper halide and thiourea derivatives, wherein the DMTu is N, N-dimethylthiourea, the TMTU is tetramethylthiourea, and the ETu is ethylene thiourea; and the formed copper complex further includes a complex of Cu₄(Tu)₁₀(NO₃)•Tu•3H₂O formed by a copper nitrate salt and a thiourea.

Further, the tin complex is selected from one or more of Sn(X)_{y}Cl₄, Sn(X)_{y}F₄, Sn(X)_{y}Br₄, Sn(X)_{y}I₄, and Sn(X)_{y}(CH₃COO)₄, wherein X is selected from one of DMSO, DMF, ethanol, and N-methylpyrrolidone, and y is a natural number greater than zero.

Further, the zinc salt is a divalent zinc compound, including but not limited to zinc halide, zinc acetate, zinc nitrate, and zinc sulfate.

Further, the amount of thiourea: the amount of copper element, in the precursor solution, is (0 to 1):1.

Further, provided in the precursor compound is as follows.

The amount of copper element: the amount of tin element is (1.5 to 2.5): 1.

The amount of zinc element: the amount of the tin element is (0.9 to 1.5): 1.

The amount of sulfur elements: a sum of the amounts of the copper element, the tin element and the zinc element is (1.0 to 6.0): 1.

Further, provided in the precursor compound is as follows.

The concentration of copper element in the solution is 0.05 mol/L to 5 mol/L.

The concentration of tin element in the solution is 0.05 mol/L to 5 mol/L.

The concentration of zinc element in the solution is 0.05 mol/L to 5 mol/L.

The concentration of sulfur element in the solution is 0.15 mol/L to 5 mol/L.

The present invention further discloses a method for preparing the precursor solution for the CZTS thin film solar cell. A specific method for preparing the precursor solution is a step-by-step preparation method: taking a DMSO or DMF as a solvent, dissolving the copper complex and the thiourea in the solvent to prepare solution one, wherein the amount of thiourea: the amount of copper element in the precursor solution is not greater than 1; dissolving the tin complex and the zinc salt in the solvent to prepare solution two; and mixing the solution one and the solution two to obtain a clear and transparent precursor solution.

Further, the methods for preparing the copper complex and the tin complex are as follows.

A synthesis of the copper complex is conducted as follows: the thiourea is dissolved in deionized water, the copper salt is added to the solution after the thiourea is completely dissolved, wherein the ratio of the amount of the added thiourea to the amount of the added copper salt is 3:1, and a temperature of the solution during the reaction is 70 °C; the solution is filtered after the copper salt dissolved, the solution is held to stand still, and the solution is cooled slowly, crystals of the target-product copper complex are precipitated from the solution, and a crystal product is taken out and dried.

A synthesis of the tin complex is conducted as follows: a tetravalent tin salt is taken in a round-bottomed flask, the mouth of the flask is sealed, the organic compound solvent DMF or DMSO is taken and the solvent is injected into the flask, wherein the ratio of the amount of organic compounds and the amount of the tin salt in the solvent is 2 to 20; the tin salt is reacted with the DMF or the DMSO solvent to generate a large amount of white precipitates; the precipitates are cleaned with ethanol and dried to obtain the corresponding target-product tin complex.

Provided are the above method for preparing the precursor solution of the CZTS thin film solar cell and an application thereof in preparing the CZTS solar cell, which includes the following steps.
(1) A synthesis of the copper complex is conducted as follows: a certain amount of thiourea is dissolved in deionized water, the copper salt is added to the solution after the thiourea is completely dissolved, wherein the ratio of the amount of the added thiourea to the amount of the added copper salt is 3:1, and the temperature of the solution during the reaction is 70 °C; after the two substances are basically dissolved, the solution is filtered, the solution is held to stand still, and the solution is cooled slowly, crystals of the target-product copper complex are precipitated from the solution, and the above-mentioned crystal product is taken out and dried.
(2) A synthesis of the tin complex is conducted as follows: a certain amount of tetravalent tin salt is added in a round-bottomed flask, the mouth of the flask is sealed, the superfluous organic compound solvent DMF or DMSO is taken and the solvent is injected into the flask, the reaction generates a large amount of white precipitates; and the precipitates are filtered and cleaned with ethanol, then dried to obtain the corresponding target-product tin complex.
(3) The precursor solution is prepared as follows: the DMSO or DMF is taken as the solvent, the copper complex, the tin complex, the divalent zinc compound and the thiourea are dissolved in the solvent to obtain a clear and transparent precursor solution.
(4) The prepared precursor solution obtained from Step (1) is spin-coated on molybdenum glass, to be annealed to produce a CZTS precursor thin film.
(5) The CZTS precursor thin film produced from Step (2) is heated in an atmosphere of Se, and the S atoms are replaced with Se atoms partially or entirely to produce a CZTS film material.
(6) The CZTSSe thin film obtained after the selenization reaction is taken out and the CZTSSe thin film is immersed in ultrapure water, and then the CZTSSe thin film is placed in a water-jacketed beaker containing ammonia water, cadmium sulfate and thiourea solution, the reaction is carried out under heating, a layer of CdS is deposited on a surface of the CZTSSe thin film.
(7) 50 nm Intrinsic Zinc Oxide (i-ZnO) and 250 nm Indium Tin Oxide (ITO) are sequentially sputtered on the surface of the sample in Step (4) as a window layer by a magnetron sputtering technology.
(8) A grid electrode with 50nm metal Ni and 1 µm Al is evaporated on the surface of the sample obtained in Step (5) by a thermal evaporation method.

Further, the reaction conditions of spin-coating and annealing in Step 4 are as follows: the spin-coating speed is 500 rpm to 8000 rpm, the time is 10 s to 600 s, the annealing temperature is 200 °C to 500 °C, the annealing time is 20 s to 120 s, and the spin-coating-annealing cycle is repeated for 3 times to 15 times.

Further, the steps of the selenization reaction in Step 5 are as follows.

(5-1) The copper-zinc-tin-sulfur thin film and 0.2 g to 0.5 g of selenium pallets are placed in a graphite box, and then the graphite box is put into a quartz tube slowly and horizontally, wherein gas pipelines are connected to the flanges at both ends of the quartz tube, and pressure gauges and gas valves are connected to the gas pipelines.

(5-2) The gas in the quartz tube is pumped with a mechanical pump to below 3×10⁻² Torr, and then the quartz tube is filled with argon until the gas pressure in the tube becomes a normal pressure.

(5-3) The tube furnace heating procedure is started, wherein the target temperature is 500 °C to 600 °C, the heating rate is 0.2 °C to 10 °C/s, and the annealing is performed at the target temperature for 5 minutes to 30 minutes.

(5-4) After the annealing procedure is terminated, the product is naturally cooled to a room temperature.

Beneficial effects lie in the following. Compared with the prior art, the method for preparing the precursor solution of the CZTS thin film solar cell provided by the present invention has the following advantages.
1. The present invention discloses two kinds of simple methods for synthesizing metal complexes, which are used to prepare a stable precursor solution. The use of metal complexes maintains the initial valence state of metal precursors and avoids a redox reaction between monovalent copper ions and tetravalent tin, and therefore, the obtained precursor solution has an excellent quality, a good stability and a good repeatability.
2. The precursor solution prepared by the present invention can prepare an impurity phase-free CZTS light-absorbing material having a high quality, and the prepared CZTS thin film solar cell has a high photoelectric conversion efficiency.
3. The use of metal complexes simplifies the solution preparation process, greatly shortens the solution preparation time, and is conducive to the industrial production.

### BRIEF DESCRIPTION OF THE DRAWINGS

FIG 1 illustrates a physical picture of a copper complex Cu(Tu)₃Cl formed by cuprous chloride with thiourea in the embodiments.
FIG 2 illustrates a physical picture of a tin complex Sn(DMF)₂Cl₄ formed by tin tetrachloride and N,N-dimethylformamide in Example 3.
FIG 3 illustrates a physical picture of a DMSO precursor solution in Example 1.
FIG 4 illustrates a physical picture of a DMF precursor solution in Example 3.
FIG 5 illustrates an X-ray diffraction pattern of a precursor thin film in Example 1.
FIG 6 illustrates an X-ray diffraction pattern of the precursor thin film in Example 3.
FIG 7 illustrates an X-ray diffraction pattern of an absorption layer thin film in Example 1.
FIG 8 illustrates an X-ray diffraction pattern of the absorption layer thin film in Example 3.
FIG 9 illustrates a Raman spectrum of the precursor thin film in Example 1.
FIG 10 illustrates a Raman spectrum of the precursor thin film in Example 3.
FIG 11 illustrates a Raman spectrum of the absorption layer thin film in Example 1.
FIG 12 illustrates a Raman spectrum of the absorption layer thin film in Example 3.
FIG 13 illustrates a scanning electron microscope image (a cross section of a film layer) of the absorption layer thin film in Example 1.
FIG 14 illustrates a scanning electron microscope image (a cross section of a film layer) of the absorption layer thin film in Example 3.
FIG 15 illustrates a scanning electron microscope image (a surface of a film layer) of the absorption layer thin film in Example 1.
FIG 16 illustrates a scanning electron microscope image (a surface of a film layer) of the absorption layer thin film in Example 3.
FIG 17 illustrates a voltage-current characteristic curve for a device of a CZTSSe solar cell in Example 1 under a standard sunlight intensity of AM1.5G
FIG 18 illustrates a voltage-current characteristic curve for the device of the CZTSSe solar cell in Example 3 under the standard sunlight intensity of AM1.5G.

### DETAILED DESCRIPTION OF THE EMBODIMENTS

The present invention discloses a method for preparing a precursor solution for high-efficiency CZTS thin film solar cells, and a preparation and an application of a photovoltaic device. The present invention discloses two types of simple metal complexes which are capable of formulating a high-quality precursor solution. The precursor solution, which is formulated by using the metal complexes as precursor compounds, has a good stability and repeatability, and can be used to prepare an impurity phase-free CZTS thin film light-absorbing material having a high crystallization quality and a good thin film morphology, and the CZTS thin film solar cell prepared therefrom has a high photoelectric conversion efficiency. The use of metal complexes simplifies the formulation procedure of the precursor solution, improves the quality of the precursor solution, improves the energy conversion efficiency of a photovoltaic device, and has a great industrial potential application scope.

The embodiments of the present invention will be described in detail below. The present embodiments are implemented on the premise of the technical solutions of the present invention, and provide detailed implementations and a specific operation process, but the protection scope of the present invention is not limited to the following examples.

The present invention can be better understood from the following examples. However, those skilled in the art would easily understand that the specific material ratios, process conditions and results described in the examples are only used to illustrate the present invention, and should not and will not limit the present invention described in detail in the claims.

### Example 1

Step 1: The preparation of the copper complex.

45.67 g (0.6 mol) of thiourea are weighed and dissolved in 100 mL of deionized water, heated and stirred to keep the solution temperature at 70 °C, after the thiourea is completely dissolved, 19.8 g (0.2 mol) of cuprous chloride are weighed and added into the solution, after reacting for 30 minutes, most of the cuprous chloride are dissolved, the solution is filtrated when still warm, and the filtrate is held to stand still for natural cooling. After a period of time, the colorless and transparent crystals precipitated in the filtrate are the target-product copper complex Cu(TU)₃Cl, and then crystals are filtered and dried.

Step 2: The preparation of the tin complex.

12.53 g of stannic chloride are weighed and taken in a round-bottomed flask, the mouth of the flask is sealed, 50 mL of DMSO are taken and injected into the flask by an injector. The two substances react violently when they come into contact and the reaction generates a large amount of white precipitates. After the reaction is complete, the reaction solution is filtered to obtain white precipitates, and the precipitates are washed with ethanol for several times, then are dried to obtain the corresponding target product Sn(DMSO)₄Cl₄.

Step 3: The preparation of the precursor solution.

8 mL of DMSO are weighed and put into a reagent bottle, 20 g (6.12 mmol) of the copper complex prepared in Step 1, 1.667 g (4 mmol) of the tin complex Sn(DMSO)₄Cl₄ prepared in Step 2, 0.734 g (4 mmol) of zinc acetate and 0.2 g of thiourea are weighed and added into the reagent bottle, and stirred at the room temperature until completely dissolved.

Step 4: The preparation of the CZTS precursor thin film.

The molybdenum-coated glass is ultrasonically cleaned in acetone and isopropanol for 10 minutes respectively and then air-dried. The precursor solution prepared in Step 3 is spin-coated in a glove box, and the spin-coating parameters are a spin-coating speed of 1500 rpm and a spin-coating time of 60 s. After the spin-coating, the samples are annealed on a hot stage at 420 °C for 2 minutes. The above spin-coating-heating process is repeated 7 times to obtain the CZTS precursor thin film.

Step 5: The preparation of the CZTSSe thin film.

The two precursor thin film samples (2.45 cm × 2.45 cm) prepared in Step 4 are placed in the graphite box, about 0.35 g of Se pallets are weighed and placed in the graphite box symmetrically, the valve is closed tightly, and after the vacuum is evacuated to make the degree of vacuum in the tube reach 3 × 10⁻² Torr, argon gas is introduced into the tube, and the above operation is repeated 3 times to purge the air in the tube to ensure that the selenization reaction is carried out in an anhydrous and oxygen-free environment. The tube furnace heating program is started with a target temperature of 550 °C and a heating rate of 2 °C/s, and the samples are annealed at 550 °C for 20 minutes, after annealing, the samples are naturally cooled to the room temperature.

Step 6: The preparation of the buffer layer CdS.

After the selenization reaction, the samples in the graphite box are taken out and immersed in ultrapure water for 6 minutes, and then the CdS buffer layer is deposited by a chemical bath deposition method (CBD). In Step 1, the temperature of the water bath is set to 65 °C, 22 mL of thiourea solution with a concentration of 0.75 mol/L and 22 mL of cadmium sulfate solution with a concentration of 0.015 mol/L and 28 mL of ammonia water are measured with a graduated cylinder, respectively. In Step 2, the measured ammonia water and cadmium sulfate solution are poured into 150 mL of ultrapure water and mixed, the mixed solution is poured into a water-jacketed beaker, and then the sample that is immersed in ultrapure water is taken out and put into the water-jacketed beaker with mixed solution. The interlayer of the water-jacketed beaker is filled with circulating water at 65°C for heating and start timing. In Step 3, the pre-measured thiourea solution is poured into the reaction solution after one minute, as the reaction progresses, the solution changes from clear to pale yellow, and eventually to a yellow translucent suspension. In Step 4, the sample is taken out after the solution has reacted for eight minutes, the surface of the sample is rinsed with ultrapure water to remove the CdS pallets adsorbed on the surface, and then the sample is dried with a nitrogen gun.

Step 7: The preparation of the window layer (ZnO/ITO).

Intrinsic zinc oxide (i-ZnO) and indium tin oxide (ITO) are deposited on the above samples by a magnetron sputtering method as window layer materials. The i-ZnO is sputtered by the magnetron sputtering instrument, the sputtering power is 80 W, the environment is pure argon gas, the air pressure is 0.5 Pa, and the thickness of the film layer is 50 nm. The sputtering power of sputtering the ITO is 60 W, the sputtering pressure in the pure argon environment is 0.5 Pa, and the thickness of the film layer is 200 nm.

Step 8: The preparation of the electrode (Ni/Al).

The cathode of the battery is composed of metallic Ni and Al, prepared by a thermal evaporation method. The thicknesses of Ni and Al are 50 nm and 500 nm, respectively.

The CZTS precursor film layer and the absorption film layer prepared according to the above process have no impurity phase. The absorption layer material has a high crystallinity and a good morphology, and the energy conversion efficiency of the prepared CZTS solar cell is 10.9%.

### Example 2

In Step 1, the preparation of the copper complex is conducted. The operation method of this step is the same as that of Example 1.

In Step 2, 12.53 g of stannic chloride are weighed and taken in a round-bottomed flask, the mouth of the flask is sealed. 50 mL of DMF are taken and injected into the flask by an injector. The two substances react violently when they come into contact and the reaction generates a large amount of white precipitates. After the reaction is complete, the reaction solution is filtered to obtain white precipitates, and the precipitates are washed with ethanol for several times, then are dried to obtain the corresponding target product Sn(DMF)₂Cl₄.

In Step 3, the preparation of the precursor solution is conducted. 8 mL of DMSO are weighed and put into a reagent bottle, 20 g (6.12 mmol) of the copper complex prepared in Step 1, 1.626 g (4 mmol) of the tin complex Sn(DMF)₂Cl₄ prepared in Step 2, 0.734 g (4 mmol) of zinc acetate and 0.2 g of thiourea are weighted and added into the reagent bottle, and stirred at the room temperature until completely dissolved.

In Step 4 to Step 8, the operation methods are the same as those of Example 1.

### Example 3

In Step 1, the preparation of the copper complex. The operation method of this step is the same as that of Example 1.

In Step 2, 12.53 g of stannic chloride are weighed and taken in a round-bottomed flask, the mouth of the flask is sealed, 50 mL of DMSO are taken and injected into the flask by an injector. The two substances react violently when they come into contact and the reaction generates a large amount of white precipitates. After the reaction is complete, the reaction solution is filtered to obtain white precipitates, and the precipitates are washed with ethanol for several times, then are dried to obtain the corresponding target product Sn(DMSO)₄Cl₄.

In Step 3, the preparation of the precursor solution is conducted. 8 mL of DMF are taken and put into a reagent bottle, 20 g (6.12 mmol) of the copper complex Cu(Tu)₃Cl prepared in Step 1, 1.667 g (4 mmol) of the tin complex Sn(DMSO)₄Cl₄ prepared in Step 2, 0.734 g (4 mmol) of zinc acetate and 0.2 g of thiourea are weighted and added into the reagent bottle, and stirred at the room temperature until completely dissolved.

In Step 4 to Step 8, the operation methods are the same as those of Example 1.

### Example 4

In Step 1, the preparation of the copper complex is conducted. The operation method of this step is the same as that of Example 1.

In Step 2, 12.53 g of stannic chloride are weighed and taken in a round-bottomed flask, the mouth of the flask is sealed, 50 mL of DMF are taken and injected into the flask by an injector. The two substances react violently when they come into contact and the reaction generates a large amount of white precipitates. After the reaction is complete, the reaction solution is filtered to obtain white precipitates, and the precipitates are washed with ethanol for several times, then are dried to obtain the target product of the tin complex Sn(DMF)₂Cl₄.

In Step 3, the preparation of the precursor solution is conducted. 8 mL of DMF are taken and put into a reagent bottle. 20 g (6.12 mmol) of the copper complex prepared in Step 1, 1.626 g (4 mmol) of the tin complex Sn(DMF)₂Cl₄ prepared in Step 2, 0.734 g (4 mmol) of zinc acetate and 0.2 g of thiourea are weighted and added into the reagent bottle, and stirred at the room temperature until completely dissolved.

In Step 4 to Step 8, the operation methods are the same as those of Example 1.

The embodiments of the present invention provide four new preparation methods for preparing precursor solutions for high-efficiency CZTS solar cells, that is, by using the metal complexes as precursor compounds to prepare precursor solutions, the CZTS thin film light-absorbing material having a high crystallization quality, a good thin film morphology and no impurity phase is prepared, and then a high-efficiency CZTS solar cell is prepared.

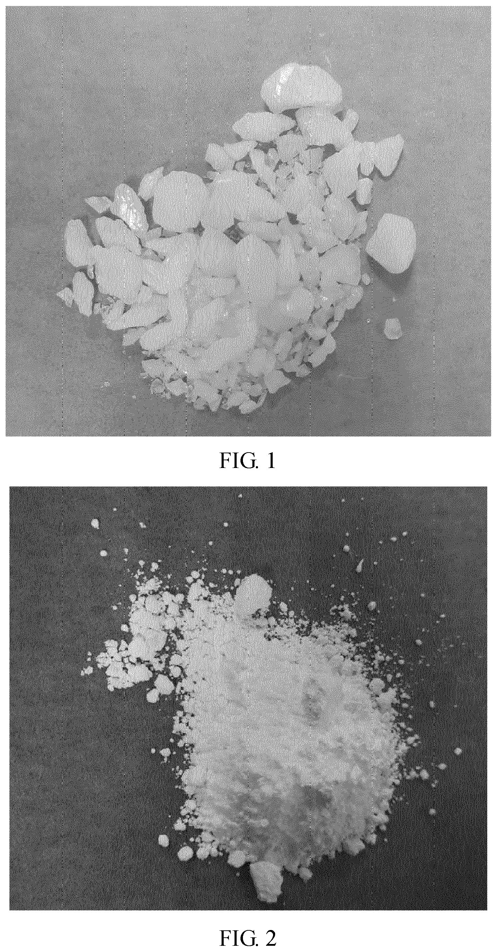

FIG 1 and FIG 2 illustrate physical pictures of a copper complex and a tin complex respectively, and their chemical components as analyzed by an elemental analyzer, are Cᵤ(Tᵤ)₃Cl and Sn(DMF)₂Cl, respectively.

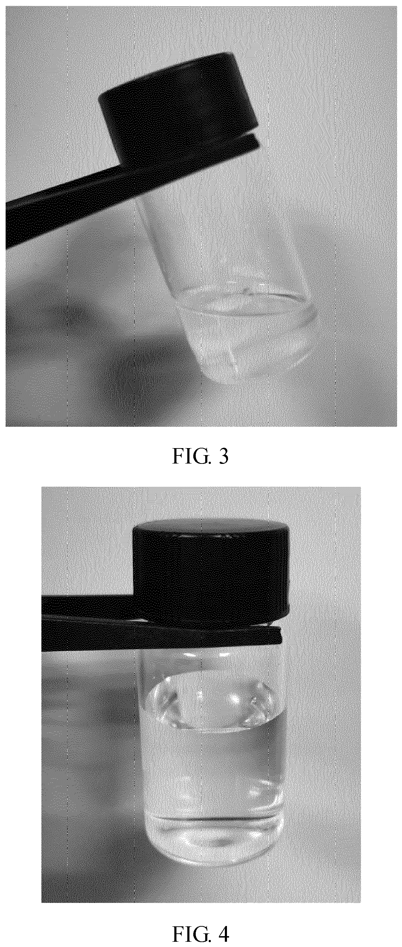

FIG 3 and FIG 4 illustrate physical pictures of the precursor solutions prepared in the DMSO and DMF solvents based on the above two metal complexes, respectively, which can be observed that both solutions are clear and transparent without precipitation and impurities, and the stability is good, indicating that its solution is of a high quality.

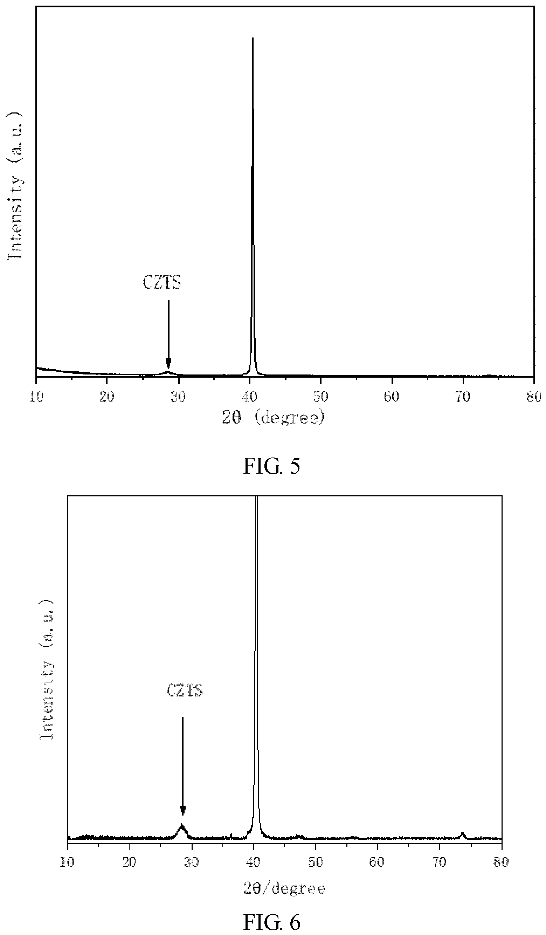

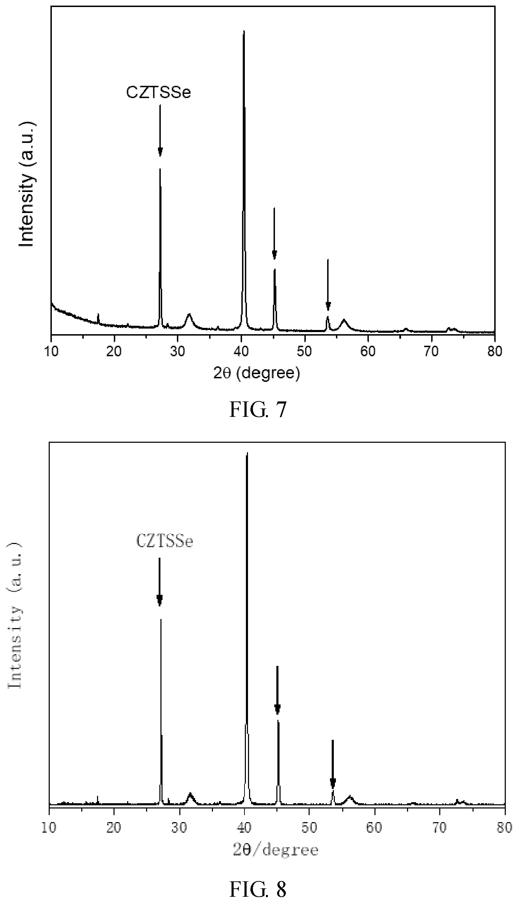

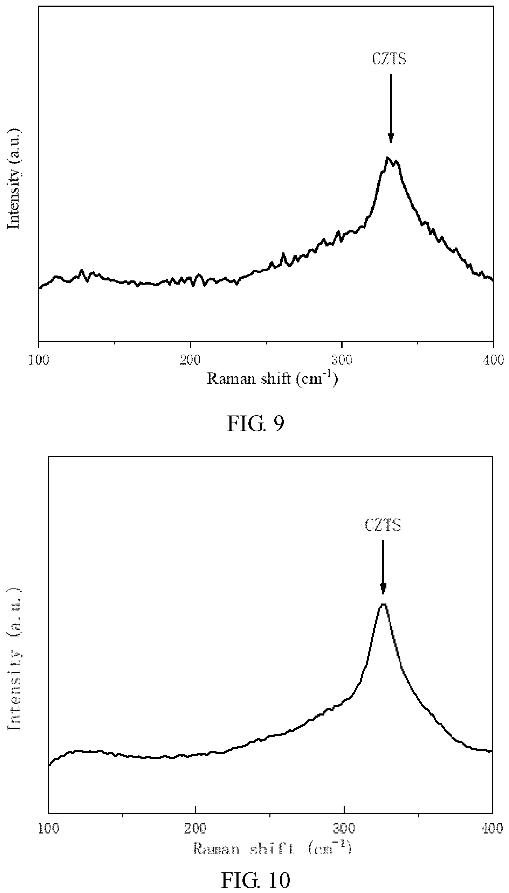

FIG 5 and FIG 6 illustrate X-ray diffraction patterns of the precursor thin films formed by the spin-coating and the annealing of the two precursor solutions. The two precursor thin films show weak diffraction at diffraction angles of 2-Theta = 28.5, 47.3, and 56.1 degrees. These diffraction peaks correspond to the (112), (220), (312) crystal planes (PDF#26-0575) of the copper zinc tin sulfide phase (CZTS), respectively, indicating that the CZTS phase is formed in both groups of the precursor films. FIG 9 and FIG 10 illustrate Raman spectra of the precursor thin films, both precursor thin films have obvious Raman vibration peaks at the Raman shift of 337 cm⁻¹, which corresponds to the CZTS phase. Both of these characterization methods show that there is only a single CZTS phase in the precursor thin film, and no other impurity phase, which is beneficial to the subsequent growth and crystallization of the thin film. FIG 7 and FIG 8 illustrate the X-ray diffraction patterns of the CZTSSe absorption layer thin films formed by the selenization reaction of the two precursor thin films. It can be seen from the figures that there are strong diffraction peaks at Theta = 27.1, 45.0, and 53.4 on the two CZTSSe absorption layer thin films, these diffraction peaks correspond to the (112), (204), (312) crystal planes of the CZTSe phase, respectively, indicating that the absorption layer thin film after selenization are all CZTSe phases, and no other impurity phases can be observed.

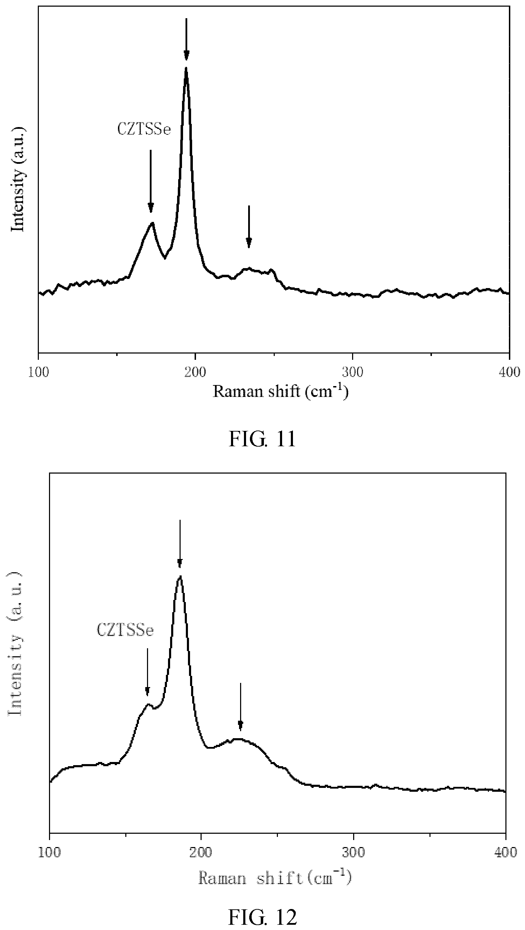

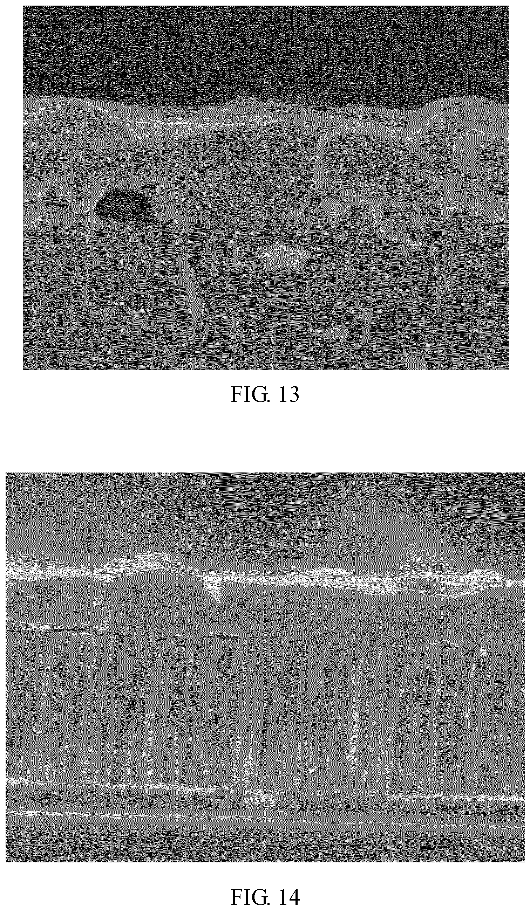

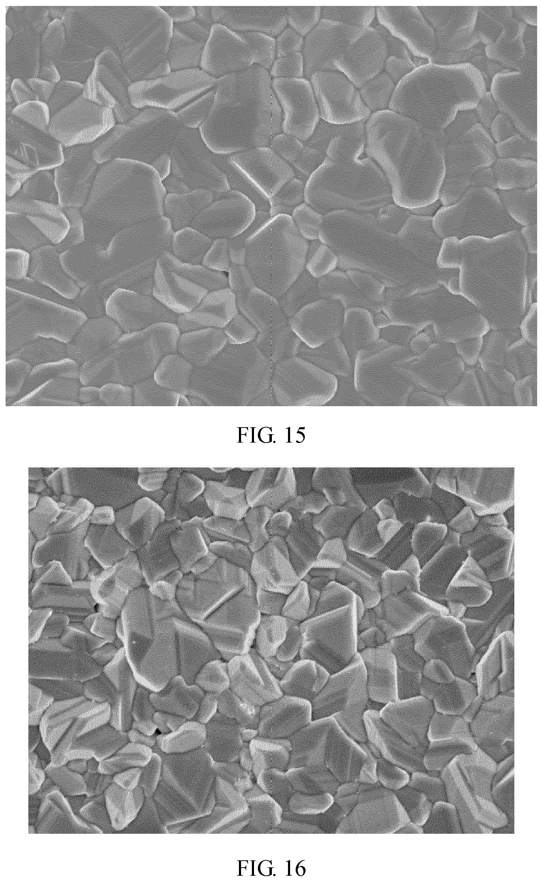

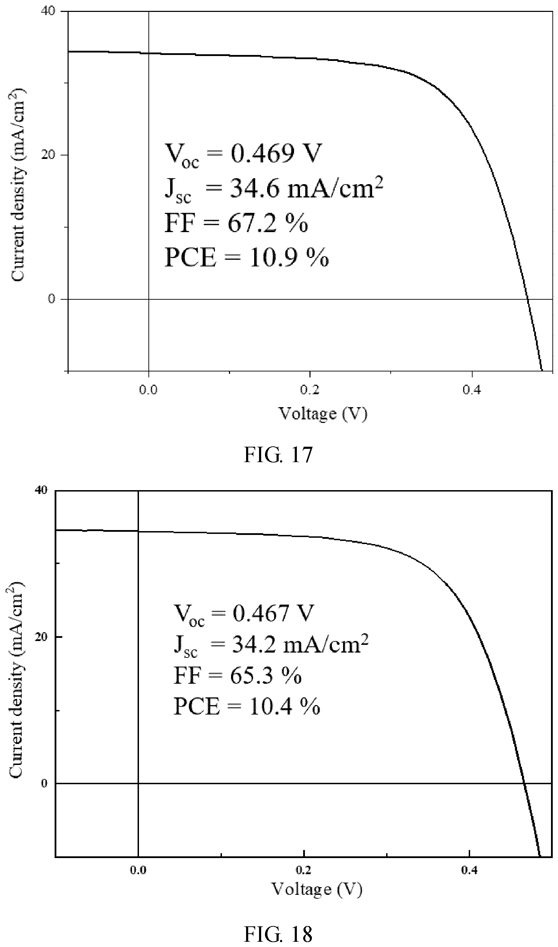

FIG 11 and FIG 12 illustrate the Raman spectra of the CZTSSe absorption layer thin films. It can be seen from the figures that the two precursor thin films have obvious Raman vibration peaks at the Raman shifts of 172, 193, and 231 cm⁻¹, which correspond to the CZTSe phase, and no Raman vibration peaks of other impurity phases can be observed, which indicates that the prepared absorption layer thin films are high-quality CZTSSe thin films. In combination with the scanning electron microscope photos of the absorption layer thin films with a high crystallinity, flat and dense, and no impurity phase that are observed in FIGS. 13, 14, 15 and 16, it is further shown that the absorption layer thin films prepared in the examples are of a high quality. The two groups of light-absorbing film layers are prepared into solar cell devices and their photovoltaic performance are tested. Their voltage-current characteristic curves are as illustrated in FIGS. 17 and 18. The photoelectric conversion efficiency of both devices exceed 10%, reaching an international advanced level.

In summary, a stable, clear and transparent precursor solution having a high quality is prepared by the technical solutions of the present invention, and the precursor solution is applied to the preparation of CZTSSe thin film materials and photovoltaic devices, and eventually, a CZTSSe thin film material with a high crystal quality, a good morphology and no impurity phase and a photovoltaic device with an energy conversion efficiency of more than 10% are obtained, which shows a remarkable advancement of the present invention.

The above are only the preferred implementations of the present invention. It should be pointed out that for those of ordinary skill in the art, without departing from the concept of the present invention, several modifications and improvements can be made, and these modifications and improvements should also be regarded as the protection scope of the present invention.

## Claims

1. A precursor solution for CZTS thin film solar cell, wherein the precursor solution is prepared by using a DMSO or a DMF as a solvent, and precursor compounds as solutes; the precursor compound is composed of metal complexes, a metal salt and a thiourea, wherein the metal complexes are a copper complex formed by a copper salt, and a thiourea or thiourea derivative, and a tin complex formed by a tin salt, and a DMF or DMSO, and the metal salt is a divalent zinc salt; and the precursor compound is dissolved in the solvent of the DMSO or DMF to obtain a stable, clear and transparent precursor solution.

2. The precursor solution for the CZTS thin film solar cell according to claim 1, wherein the copper complex is a complex formed by a copper salt, and a thiourea or derivative, including a complex of Cu(Tu)₃X formed by a copper halide and a thiourea, wherein X is a halogen element including F, Cl, Br, or I, the formed copper complex includes Cu(Tu)₃C1, [Cu₂(Tu)₆]C1₂•2H₂O, or Cu(Tu)₃Br, the formed copper complex further includes a complex of Cu(DMTu)₃Br, Cu(TMTu)₃C1, or [Cu(ETu)₂Br]₂ formed by a copper halide and a thiourea derivative, wherein the DMTu is N, N-dimethylthiourea, the TMTU is tetramethylthiourea, and the ETu is ethylene thiourea; and the formed copper complex further includes a complex of Cᵤ₄(Tu)₁₀(NO₃)•Tu•3H₂O formed by a copper nitrate salt and a thiourea.

3. The precursor solution for the CZTS thin film solar cell according to claim 1, wherein the tin complex is selected from one or more of Sn(X)_{y}Cl₄, Sn(X)_{y}F₄, Sn(X)_{y}Br₄, Sn(X)_{y}I₄, and Sn(X)_{y}(CH₃COO)₄, X is selected from one of DMSO, DMF, ethanol, and N-methylpyrrolidone, and y is a natural number greater than zero.

4. The precursor solution for the CZTS thin film solar cell according to claim 1, wherein the zinc salt is a divalent zinc compound, including but not limited to zinc halide, zinc acetate, zinc nitrate, and zinc sulfate.

5. The precursor solution for the CZTS thin film solar cell according to claim 1, wherein an amount of thiourea: an amount of copper element in the precursor solution is not greater than 1.

6. The precursor solution for the CZTS thin film solar cell according to claim 1, wherein in the precursor compounds,
an amount of copper element: an amount of tin element is (1.5 to 2.5): 1;
an amount of zinc element: the amount of the tin element is (0.9 to 1.5): 1; and
an amount of sulfur element: a sum of the amounts of the copper element, the tin element and the zinc element is (1.0 to 6.0): 1.

7. The precursor solution for the CZTS thin film solar cell according to claim 1, wherein in the precursor compound,
a concentration of copper element in the solution is 0.05 mol/L to 5 mol/L;
a concentration of tin element in the solution is 0.05 mol/L to 5 mol/L;
a concentration of zinc element in the solution is 0.05 mol/L to 5 mol/L; and
a concentration of sulfur element in the solution is 0.15 mol/L to 5 mol/L.

8. A method for preparing the precursor solution for the CZTS thin film solar cell according to any one of claims 1 to 7, wherein a specific method for preparing the precursor solution is a step-by-step preparation method: taking a DMSO or DMF as a solvent, dissolving the copper complex and the thiourea in the solvent to prepare a solution one; dissolving the tin complex and the zinc salt in the solvent to prepare solution two; and mixing the solution one and the solution two to obtain a clear and transparent precursor solution.

9. The method for preparing the precursor solution for the CZTS thin film solar cell according to claim 8, wherein methods for preparing the copper complex and the tin complex are as follows:
synthesizing the copper complex: dissolving the thiourea in deionized water, adding, after the thiourea is completely dissolved, the copper salt to the solution, wherein a ratio of an amount of the added thiourea to an amount of the added copper salt is 3: 1, and a temperature of the solution during the reaction is 70 °C; filtering, after dissolving the copper salt, the solution, holding the solution stand still, and cooling the solution slowly, precipitating crystals of the target-product copper complex from the solution, and taking out and drying a crystal product; and
synthesizing the tin complex: taking a tetravalent tin salt in a round-bottomed flask, sealing a mouth of the flask, taking the organic compound solvent DMF or DMSO and injecting the solvent into the flask, wherein a ratio of an amount of organic compounds and an amount of the tin salt in the solvent is 2 to 20; reacting the tin salt with the DMF or the DMSO solvent to generate a large amount of white precipitates, cleaning the precipitates with ethanol and drying the precipitates to obtain the corresponding target-product tin complex.

10. An application of the precursor solution for the CZTS thin film solar cell according to any one of claims 1 to 7 in preparing a CZTS solar cell, wherein a method for preparing the CZTS solar cell includes following steps:
(1) spin-coating the prepared precursor solution on molybdenum glass to be annealed to produce a CZTS precursor thin film;
(2) heating the precursor thin film in an atmosphere of Se to carry out a selenization reaction, and replacing S atoms, partially or entirely, with Se atoms to produce a CZTSSe thin film material;
(3) taking out the CZTSSe thin film after the selenization reaction and immersing the CZTSSe thin film in ultrapure water, and then placing the CZTSSe thin film in a water-jacketed beaker containing ammonia water, cadmium sulfate and thiourea solution, carrying out the reaction under heating, and depositing a layer of CdS on a surface of the CZTSSe thin film;
(4) sequentially sputtering, by a magnetron sputtering technology, ZnO and ITO on the surface of the sample in Step (3) as a window layer; and
(5) evaporating, by a thermal evaporation method, metal Ni and Al on the surface of the sample obtained in Step (4) as a cathode.
